# EUROPÄISCHE PATENTSCHRIFT

(11) **EP 2 586 052 B1**
(45) Veröffentlichungstag und Bekanntmachung des Hinweises auf die Patenterteilung: **20.08.2014**
(21) Anmeldenummer: 11732397.2
(22) Anmeldetag: 15.06.2011
(51) Int. Cl.: H01J 37/05, H01J 37/305, H01J 49/28

(54) **VORRICHTUNG ZUR STRUKTURIERUNG VON FESTKÖRPERFLÄCHEN MIT IONENSTRAHLEN AUS EINEM IONENSTRAHLSPEKTRUM**
APPARATUS FOR STRUCTURING SOLID SURFACES USING ION BEAMS FROM AN ION BEAM SPECTRUM
DISPOSITIF PERMETTANT DE STRUCTURER DES SURFACES DE CORPS SOLIDES AU MOYEN DE FAISCEAUX IONIQUES PROVENANT D'UN SPECTRE DE FAISCEAUX IONIQUES

(30) Priorität: 22.06.2010 DE 102010030372
(43) Veröffentlichungstag der Anmeldung: 01.05.2013
(73) Patentinhaber: Dreebit GmbH, 01109 Dresden (DE)
(72) Erfinder: ZSCHORNACK, Günter, 01796 Pirna (DE); SCHMIDT, Mike, 01809 Heidenau (DE); GROSSMANN, Frank, 01458 Ottendorf-Okrilla (DE)
(74) Vertreter: Sperling, Thomas
(86) Internationale Anmeldenummer: PCT/EP2011/059939
(87) Internationale Veröffentlichungsnummer: WO 2011/160990

(56) Entgegenhaltungen:
- WO-A1-97/13268
- JP-A- 58 169 858
- JP-A- 2000 149 843
- ZSCHORNACK G ET AL: "Status report of the Dresden EBIS/EBIT developments", REVIEW OF SCIENTIFIC INSTRUMENTS, AIP, MELVILLE, NY, US, Bd. 81, Nr. 2, 23. Februar 2010 (2010-02-23), Seiten 2A512-2A512, XP012134734, ISSN: 0034-6748, DOI: 10.1063/1.3267846
- SCHMIDT M ET AL: "A compact electron beam ion source with integrated Wien filter providing mass and charge state separated beams of highly charged ions", REVIEW OF SCIENTIFIC INSTRUMENTS, AIP, MELVILLE, NY, US, Bd. 80, Nr. 6, 8. Juni 2009 (2009-06-08), Seiten 63301-63301, XP012128325, ISSN: 0034-6748, DOI: 10.1063/1.3125628
- KENTSCH U ET AL: "X-ray spectroscopy and ion extraction at the Dresden EBIT", NUCLEAR INSTRUMENTS & METHODS IN PHYSICS RESEARCH, SECTION - B:BEAM INTERACTIONS WITH MATERIALS AND ATOMS, ELSEVIER, AMSTERDAM, NL, Bd. 205, 1. Mai 2003 (2003-05-01), Seiten 260-265, XP004424763, ISSN: 0168-583X, DOI: 10.1016/S0168-583X(03)00554-8
- ULLMANN F ET AL: "Production of a helium beam in a focused ion beam machine using an electron beam ion trap", APPLIED PHYSICS LETTERS, AIP, AMERICAN INSTITUTE OF PHYSICS, MELVILLE, NY, US, Bd. 90, Nr. 8, 23. Februar 2007 (2007-02-23), Seiten 83112-083112, XP012096177, ISSN: 0003-6951, DOI: 10.1063/1.2454699

## Beschreibung

Die Erfindung betrifft eine Vorrichtung zur Strukturierung von Festkörperflächen mit lonenstrahlen aus einem lonenstrahlspektrum, wobei das lonenstrahlspektrum aus Ionen mit verschiedenen Ladungszuständen und unterschiedlichen Massen besteht, aufweisend eine Baugruppe zur Erzeugung des lonenstrahlspektrums mit Ionen verschiedener Ladungszustände und Massen mit einer Kathode, mehreren Driftröhrensektionen, einem Kollektor und einer Anordnung von lonenextraktions- und Fokussierungslinsen auf einer gemeinsamen Strahlachse sowie einem Permanentmagnetsystem um die gemeinsame Strahlachse, wobei das erzeugte lonenstrahlspektrum in der Anordnung von Extraktions- und Fokussierungslinsen extrahiert und von da aus auf ein nachfolgendes Wienfilter fokussiert wird, das zur Ladungszustands- und Massenseparation eines extrahierten und fokussierten lonenstrahls dient, mindestens einen Deflektor der den lonenstrahl stigmatisiert, positioniert und ablenkt, und
mindestens ein Objektiv, das den lonenstrahl auf eine sehr kleine Festkörperfläche feinfokussiert,
wobei das Wienfilter aus einer Elektrodenanordnung mit zwei Segmenten und einer zweipoligen Magnetanordnung aufgebaut ist, wobei ein angelegtes elektrisches Feld E, das orthogonal zur Bewegungsrichtung des lonenstrahlspektrums angeordnet ist und ein Magnetfeld B, welches orthogonal zur Bewegungsrichtung des lonenstrahlspektrums und orthogonal zum elektrischen Feld E ausgerichtet ist, vorgesehen sind sowie eingangsseitig eine Kollimatorblende zum Passieren des lonenstrahlspektrums und ausgangsseitig eine Massentrennblende enthält, mit der das lonenstrahlspektrum in seine lonenstrahlen entsprechend Masse und Ladungszustand zerlegt wird.

Dem allgemeinen Bestreben, Festkörper immer kleiner zu machen, um viele davon auf engstem Raum zu lokalisieren, wurde in den letzten Jahrzehnten enorme finanzielle Mittel zur Verfügung gestellt. Das Resultat sind hochentwickelte lithografische Verfahren zur Bearbeitung von Festkörpern auf der Basis von ultravioletter Strahlung, mit deren Hilfe sich z.B. viele Millionen Transistoren auf einer sehr kleinen Fläche unterbringen lassen. Feinfokussierte lonenstrahlen zum Strukturieren bzw. zur Reparatur von Halbleitermaterialien, wie z.B. Lithografiemasken, aber auch für materialanalytische Untersuchungen finden inzwischen ebenfalls verbreitet Anwendung. Für die dafür eingesetzten lonenstrahlfokussierungssysteme werden bis heute so genannte Flüssigmetallionenquellen verwendet. Diese erzeugen lonenstrahlen von wenigen Elementen mit sehr niedrigen Ladungszuständen (einfach bis zweifach geladen). Die Einflussnahme auf anwendungsrelevante Parameter, wie z.B. Sputterrate und Eindringtiefe in das zu bestrahlende Festkörpermaterial, ist dabei nur beschränkt möglich, weil die Variation der kinetischen Projektilenergie oder der potentiellen Energie auf Grund der Variation des Ladungszustands, aber auch die Variation der Projektilmasse durch Einsatz beliebiger chemischer Elemente als Projektile nur sehr beschränkt möglich ist.

Es ist eine Elektronenstoßionenquelle zur Erzeugung von einfach bis vielfach- oder höchstgeladenen Ionen in der Druckschrift DE 199 49 978 A1 beschrieben, die aus
- einer Elektronenkanone mit Kathode und Anode zur Erzeugung und Beschleunigung von Elektronen,
- einer Einrichtung zur axialsymmetrischen Fokussierung des Elektronenstrahles,
- Mitteln zur Einbringung von ionisierbaren Substanzen in eine zu öffnende und zu schließende lonenfalle im Bereich des axialsymmetrisch fokussierten Elektronenstrahles,
- einer Einrichtung zur Vernichtung der Elektronen nach dem Durchgang durch die Ionenfalle,
- sowie einer Einrichtung zur Erzeugung eines Vakuums um den axialsymmetrischen fokussierten Elektronenstrahl und die darin befindliche lonenfalle
besteht, wobei
- die Einrichtung zur axialsymmetrischen Fokussierung des Elektronenstrahls aus wenigstens zwei gegenläufig radial magnetisierten Ringstrukturen besteht und jede der Ringstrukturen den Elektronenstrahl umfasst,
- je zwei gegenläufig radial magnetisierte Ringe zu einem einheitlichen Magnetsystem zusammengefasst sind, wobei das sich schließende Magnetfeld den Aufenthaltsbereich der Ionen in der lonenfalle durchdringt,
- die Kathode eine sehr hohe Emissivität von ≥ 100 A/cm² bei einem kleinen Kathodendurchmesser aufweist und
- ein Vakuum von 10⁻⁷ bis 10⁻¹¹ mbar im Aufenthaltsbereich der Ionen während des Betriebs der Elektronenstoßionenquelle einstellbar ist.

Mit dieser Elektronenstoßionenquelle können niedriggeladene bis hochgeladene Ionen zu einem Ionenstrahl erzeugt werden, der durch das System aufeinander folgender Driftröhren unter Ultrahochvakuumbedingungen beschleunigt wird und der durch Magnetfelder von einem Permanentmagnetsystem fokussiert wird. Die Elektronenstoßionenquelle erlaubt es, lonenstrahlen mit Emittanzen in der Größenordnung von 10 π mm mrad und besser zu extrahieren.

Ein Problem besteht darin, dass der extrahierte lonenstrahl aus einem Spektrum verschiedener Ionen, d.h. aus Projektilen verschiedener Massen und Ladungszustände besteht, so dass die Strukturierung von Festkörperflächen nur mit relativ geringem Auflösungsvermögen durchgeführt werden kann.

Eine Bestrahlungseinrichtung ist in der Druckschrift US 5,849,093 A beschrieben, die zur Säuberung und Glättung von Festkörperflächen durch Ionen aus Plasmaionenquellen dient, wobei in der Bestrahlungseinrichtung die Ionen durch klassische lonenoptiken als lonenstrahl, bestehend aus unterschiedlichen, aus der Plasmaionenquelle extrahierten Ionen, auf einen Festkörper geschossen werden oder die Ionen aus der gleichen Quelle über einen Dipolmagneten ladungszustandsepariert ebenfalls auf den Festkörper geführt werden.

Ein Problem besteht darin, dass durch die Verwendung eines Dipolmagneten die verschiedenen lonenspezien zwar getrennt werden können, aber der Gesamtaufbau der Anlage sehr groß und unhandlich ist.

Eine Anlage zur Röntgenradiografie mit hochgeladenen Ionen ist in der Druckschrift US 6,115,452 A beschrieben, wobei in der Anlage ein Strahl hochgeladener Ionen durch eine Ausblendung mit Hilfe eines Diaphragmas auf Strahldurchmesser von 1 bis 250 µm oder größer ausgebildet wird und ein Target zur Produktion von Röntgenstrahlung anregt.

Ein Problem besteht darin, dass durch die Ausblendung mithilfe eines Diaphragmas auf die genannten Strahldurchmesser ein wesentlicher Anteil der Strahlintensität verloren geht.

Ein Flugzeitemissionsmikroskop auf der Basis hochgeladener Ionen ist in der Druckschrift US 6,288,394 B1 beschrieben, in dem fokussierte hochgeladene Ionen als Anregungsmedium verwendet werden. In dem Mikroskop erfolgt die Produktion der hochgeladenen Ionen mit einer kryogenen EBIT. Einzelne Ionenladungszustände werden über einen Dipolmagnet separiert. Zur Gewährleistung einer hohen Auflösung oder Fokussierung der Apparatur wird u.a. eine fokussierende Linse eingesetzt, die bis zu 40 kV Linsenpotenzial erfordert.

Ein Problem besteht darin, dass durch die Verwendung eines Dipolmagneten die verschiedenen lonenspezien zwar getrennt werden können, aber der Gesamtaufbau der Anlage sehr groß und unhandlich ist sowie einen hohen Energieverbrauch aufweist.

Ein Verfahren und eine Vorrichtung zur lagegenauen Positionierung einzelner Ionen auf Substratflächen sind in der Druckschrift DE 103 47 969 A1 beschrieben, wobei die Vorrichtung ein Teil einer nach dem AFM-Verfahren arbeitenden Abtastvorrichtung ist.

Ein Problem besteht darin, dass die lonenausbeute für intensiven Bestrahlungsdurchsatz ungeeignet ist, da ein Großteil der Strahlintensität ausgeblendet wird.

Weitere Verfahren und Vorrichtungen zum Erhalt fokussierter Ionenstrahlen (engl. focussed ion beam - FIB) sind z.B. in den Druckschriften Gianuzzi, Steve: Introduction to Focussed Ion Beams, Springerverlag, 2005 und Orloff, Utlaut, Swanson: High Resolution Focussed Ion Beams, Kluwer Academic/Plenum Publishers, 2003, beschrieben, bei denen vorrangig Flüssigmetallionenquellen eingesetzt werden, die ausschließlich niedriggeladene Ionen von wenigen Elementen produzieren.

Ein Problem besteht darin, dass durch das geringe lonenstrahl- und Elementspektrum und die ausschließliche Erzeugung von niedriggeladenen Ionen das Einsatzspektrum eingeschränkt ist, da die anwendungsrelevanten Parameter - Eindringtiefe und Sputterrate - bei Beschuss von Festkörperflächen nur geringfügig variiert werden können.

Eine Vorrichtung zum Reparieren von Halbleitermasken und Strichplatten oder Zielmarken unter Verwendung von fokussierten lonenstrahlen ist in der Druckschrift DE 3890362 T1 beschrieben, die umfasst
- eine lonenquelle, die eine Mehrzahl von lonenspezies enthält, wobei eine erste dieser Mehrzahl von lonenspezies kompatibel mit dem Material ist, aus dem die Maske oder die Strichplatte oder Zielmarke aufgebaut ist, und
- eine zweite der Mehrzahl von Ionenspezies ein relativ hohes Atomgewicht im Vergleich zur ersten Spezies aufweist,
- eine Einrichtung zum Wählen eines lonenstrahles, der aus einer der ersten und zweiten lonenspezies aufgebaut ist und zum Richten eines fokussierten lonenstrahles auf ein Ziel, das eine zu reparierende Halbleitermaske oder eine Strichplatte oder Zielmarke aufweist,
- eine Einrichtung zum Fördern eines metallhaltigen Dampfes zur Fläche oder Oberfläche des Zieles,
- eine Einrichtung zum selektiven Bereitstellen einer niedrigen Spannung oder einer hohen Spannung zwischen der lonenquelle und dem Ziel, und
- eine Einrichtung zum Bilden eines Bildes des Zieles durch die Einrichtung der sekundären lonenemission.

Ein Problem besteht darin, dass es sich bei der oben angegeben lonenquelle auch um eine Flüssigmetallionenquelle handelt. Die Flüssigmetallionenquelle verfügt nicht über ein breites Spektrum von Elementen und Ladungszuständen, die für das Einstellen von Eindringtiefe und Sputterrate bei entsprechenden Oberflächenbehandlungen der Festkörper wichtig sind.

Eine Vorrichtung und ein Verfahren zur hochsensitiven Wasserstoffdetektion mit langsamen hochgeladenen Ionen sind in der Druckschrift US 5,528,034 A beschrieben, wobei die Vorrichtung aus einer EBIS-lonenquelle, einem Massenfilter mit davor und dahinter angeordneten Strahlblenden, einem Deflektor und Linsen enthält, wobei die EBIS-lonenquelle aus einer Kathode, einer Driftröhrensektion, einem Kollektor und einer lonenlinse auf einer gemeinsamen Achse sowie einem Magnetsystem um die gemeinsame Achse besteht. Der zugehörige Massenfilter ist als Wienfilter ausgebildet, bei dem Elektroden und Magnete derart ausgerichtet angeordnet sind, dass das entstehende elektrische Feld und das sich ausbildende magnetische Feld senkrecht zueinander und zur Bewegungsrichtung des lonenstrahls gerichtet sind. Der in ein vakuumbelastetes Gehäuse durch eine eingangsseitige Blende hindurch einfallende lonenstrahl wird durch die Felder abgelenkt und separiert und ein Teil des lonenstrahles verlässt das Gehäuse durch eine ausgangsseitig angeordnete Blende zur weiteren Fokussierung.

Ein Problem besteht darin, dass der oben beschriebene Aufbau eine kryogene EBIS-Quelle enthält, die mit flüssigem Helium betrieben wird und daher durch die sehr großen geometrischen Abmaße ein großer Materialaufwand und hohe Unterhaltskosten erforderlich sind.

Aus der Druckschrift von M. Schmidt et. al, A compact electron beam ion source with integrated Wien filter providing mass and charge state separated beams of highly charged ions, Rev. Sci. Instrum. 80 (2009), 063301, geht eine bei Raumtemperatur betreibbare EBIS-Quelle mit einem mit austauschbaren Permanentmagneten ausgebildeten Wienfilter hervor. Der Wienfilter basiert auf Geschwindigkeitsseparation, das heißt die Ionen mit einer gewünschten, vorbestimmten Geschwindigkeit passieren den Filter, während andere Ionen herausgefiltert werden. Die Feldstärke und damit die Wirkung auf den lonenstrahl wird durch den Einsatz schwacher oder starker Magneten variiert.

In der Druckschrift von G.Zschornack et al., Status report of the Dresden EBIS/EBIT developments, Rev. Sci. Instrum. 81 (2010), 02A512, wird ein ähnliches Gerät beschrieben und Einsatzmöglichkeiten in Medizin und Ionenstrahltechnologie vorgestellt.

Der Erfindung liegt die Aufgabe zugrunde, eine Vorrichtung zur Strukturierung von Festkörperflächen mit lonenstrahlen aus einem lonenstrahlspektrum anzugeben, die derart ausgebildet ist, dass sowohl das lonenstrahlspektrum an eingesetzten Elementen verbreitert als auch eine Verbesserung der Bearbeitung von Festkörperflächen erreicht wird.

Die Aufgabe wird durch die Merkmale des Patentanspruchs 1 gelöst.

Die Vorrichtung zur Strukturierung von Festkörperflächen mit lonenstrahlen aus einem lonenstrahlspektrum, wobei das lonenstrahlspektrum aus Ionen mit verschiedenen Ladungszuständen und unterschiedlichen Massen besteht, weist auf:
eine Baugruppe zur Erzeugung des lonenstrahispektrums mit Ionen verschiedener Ladungszustände und Massen mit einer Kathode, mit mehreren Driftröhrensektionen und mit einem Kollektor und
eine Anordnung von lonenextraktions- und Fokussierungslinsen auf einer gemeinsamen Strahlachse sowie
ein Permanentmagnetsystem um die gemeinsame Strahlachse,
wobei das erzeugte lonenstrahlspektrum in der Anordnung von lonenextraktions- und Fokussierungslinsen extrahiert und von da aus auf ein nachfolgendes

Wienfilter fokussiert wird, das zur Ladungszustands- und Massenseparation eines extrahierten und fokussierten lonenstrahls dient, mindestens einen Deflektor, der den lonenstrahl stigmatisiert, positioniert und ablenkt, und mindestens ein Objektiv, das den lonenstrahl auf eine sehr kleine Festkörperfläche feinfokussiert,
wobei das Wienfilter aus einer Elektrodenanordnung mit mindestens zwei Segmenten und mindestens einer zweipoligen Magnetanordnung aufgebaut ist, wobei ein angelegtes elektrisches Feld E, das orthogonal zur Bewegungsrichtung des lonenstrahlspektrums angeordnet ist und ein Magnetfeld B, welches orthogonal zur Bewegungsrichtung des lonenstrahispektrums und orthogonal zum elektrischen Feld E ausgerichtet ist, vorgesehen sind sowie eingangsseitig eine Kollimatorblende zum Passieren des lonenstrahispektrums und ausgangsseitig eine Massentrennblende enthält, mit der das Ionenstrahispektrum in seine lonenstrahlen entsprechend Masse und Ladungszustand zerlegt wird,
wobei gemäß dem Kennzeichenteil des Patentanspruchs 1
im Wienfilter ein erster Magnet innerhalb eines Eisenjochs fest angeordnet ist, der einen zur Strahlachse gerichteten konvergent ausgebildeten Polschuh hat, und ein dem ersten Magnet gegenüberliegender zweiter Magnet, der mit einem am Eisenjoch beweglich ausgebildeten ersten Polschuhteil randseitig gehaltert ist und mit einem fest angeordneten, zur Strahlachse gerichteten konvergent ausgebildeten zweiten Polschuhteil versehen ist, vorhanden ist,
wobei zwischen dem Polschuh und dem zweiten Polschuhteil ein primärer Magnetpolspalt mit einem festen Spaltabstand a für den Durchgang des lonenstrahlspektrums längs der Strahlachse vorhanden ist, wobei zwischen den beiden Polschuhteilen ein sekundärer Magnetpolspalt mit einer variablen Spaltbreite b vorhanden ist, wobei sich durch die Bewegung des beweglichen Polschuhteils die Flussführung des magnetischen Feldes B im sekundären Magnetpolspalt und gleichzeitig übertragend im primären Magnetpolspalt mit dem Spaltabstand a variierbar ist.

Das Wienfilter besitzt einen primären Magnetpolspalt mit einem festen Spaltabstand a um die Strahlachse und einen sekundären Magnetpolspalt mit einer variablen Spaltbreite b, womit in Abhängigkeit von der eingestellten Spaltbreite b des sekundären Magnetpolspalts die Magnetfeldstärke B im primären Magnetpolspalt variierbar ist.

Die Spaltbreite b des sekundären Magnetpolspalts kann durch Ein- und Ausfahren des beweglichen Polschuhs, an dem der Magnet befestigt ist, am Eisenjoch eingestellt werden.

Das Wienfilter hat ein angelegtes elektrisches Feld E, das orthogonal zur Bewegungsrichtung des lonenstrahispektrums angeordnet ist, und ein Magnetfeld B, das orthogonal zur Bewegungsrichtung des lonenstrahispektrums und orthogonal zum elektrischen Feld E ausgerichtet ist.

Die Form und die Größe der Linsen- und Blendenelemente kann variabel sein.

Es ist eine Anordnung zur Fokussierung des lonenstrahlspektrums vorhanden, die enthält die Kathode, die Driftröhrensegmente und der Kollektor, die auf der Strahlachse liegen und als Elektronenstoßionenquelle dienen, wobei dem Kollektor entlang der Strahlachse die Anordnung mit lonenextraktions- und Fokussierungslinsen in der Reihenfolge nachfolgen, die enthält
a) ein erstes zylindrisches Linsensegment mit über seine axiale Ausdehnung variierenden oder konstantem Innendurchmesser,
b) ein zweites zylindrisches Linsensegment mit über seine axiale Ausdehnung konstantem Innendurchmesser,
c) ein drittes zylindrisches Linsensegment mit über seine axiale Ausdehnung konstantem Innendurchmesser und
d) ein viertes zylindrisches Linsensegment mit über seine axiale Ausdehnung konstantem Innendurchmesser,
wobei an das zylindrische Linsensegment sich die Kollimatorblende anschließt, die auf der Strahlachse eine Apertur mit variablem Durchmesser besitzt.

Die hinter dem Wienfilter angeordnete Blende auf der Strahlachse kann eine Apertur mit variablem Durchmesser besitzen und in Verbindung mit dem Wienfilter als Massentrennblende funktionieren.

Die Vorrichtung stellt eine kompakte Baugruppe dar, die die Möglichkeiten einer Vorrichtung zur Fokussierung und zur Ladungszustand- und Massenseparation von lonenstrahlen mit den Vorteilen einer EBIT als Quelle von Ionen unterschiedlicher chemischer Elemente in einem weiten Bereich von Ladungszuständen miteinander vereint.

Die Strahlblende weist zwei Funktionen auf, wobei sie zum einen der weiteren Kollimierung des lonenstrahls dient und des Weiteren durch sie in Kombination mit dem Wienfilter die Selektion eines einzelnen lonenstrahles durch eine Ausblendung der restlichen lonenstrahlen erfolgt.

Die nachfolgende Deflektoranordnung kann aus mindestens zwei hintereinander angeordneten elektrostatischen Deflektoren bestehen, wobei die Deflektoren aus mindestens vier zylindrisch angeordneten Segmenten bestehen oder vorzugsweise acht zylindrisch angeordnete Segmente besitzen.

Das nachfolgend angebrachte Objektiv kann folgenden Aufbau aufweisen:
- ein erstes Linsensegment mit konstantem Innendurchmesser,
- ein zweites Linsensegment mit über seine axiale Ausdehnung variierendem oder konstantem Innendurchmesser,
- ein drittes Linsensegment mit über seine axiale Ausdehnung variierendem oder konstantem Innendurchmesser.

Die Vorrichtung kann in einem Druckbereich von 10⁻⁷ bis 10⁻¹¹ mbar arbeiten, wobei Ionen aller im Periodensystem vorhandenen Elemente mit niedrigen bis hohen Ladungszuständen erzeugt, fokussiert und massensepariert zur Strukturierung einsetzbar sind.

Im Gegensatz zu den im Stand der Technik angegebenen Vorrichtungen zur Erzeugung von lonenstrahlen wird mit der erfindungsgemäßen Vorrichtung neben der Eigenschaft, einen selektierten fokussierten Ionenstrahl zu erzeugen, der Umstand genutzt, dass jedes Ion in Abhängigkeit von seinem Ladungszustand, der niedrig aber auch sehr hoch in der Baugruppe zur Erzeugung eines lonenstrahlspektrums eingestellt werden kann, eine ladungszustandsabhängige potentielle Energie im lonenstrahl gespeichert hat, die bei der Wechselwirkung mit zu bearbeitenden Festkörperflächen abgegeben wird.

Dabei entstehen in nanoskopisch kleinen Wechselwirkungsbereichen Leistungsdichten von 10¹² ... 10¹⁴ Wcm⁻² für jeden loneneinzeltreffer.

Außerdem können der Ladungszustand sowie die Masse des Projektils über einen weiten Bereich variiert werden und somit auch die linear abhängige kinetische Energie der Projektile. Diese Eigenschaften können in den herkömmlichen Vorrichtungen nicht genutzt werden, erweitern aber das Spektrum der Einflussnahme auf Prozesse wie Implantation und Nanostrukturieren, die präzise Oberflächenrekonstruktion, im Device Prototyping, bei der Einzelionenimplantation, in der Analytik für die Metrologie im Nanometerbereich, aber auch für neue Zugänge in der Materialforschung wesentlich.

Die Erfindung erlaubt es, mit unterschiedlichen Strömen hochgeladener Ionen oder auch im Einzelionenbestrahlungsregime zu arbeiten.

Mit der erfindungsgemäßen Vorrichtung steht eine sehr kompakte Quelle beliebig geladener Ionen einschließlich lonenselektion und Fokussierung zur Verfügung, die ohne größere Standzeiten von einem Element auf ein anderes umgerüstet werden kann und für deren Betrieb nahezu alle Elemente des Periodensystems mit nahezu allen Ladungszuständen zur Verfügung stehen. Das betrifft u.a. auch Edelgasionen wie Helium, Neon, Argon oder Xenon, die damit im Gegensatz zu dem Betrieb mit Flüssigmetallionenquellen als fokussierte lonenstrahlen zur Verfügung stehen.

Die Erfindung ermöglicht es, dass mit der Selektion einzelner lonenladungszustände Projektile mit unterschiedlichen Beträgen an gespeicherten potentiellen Energien und kinetischen Energien für den Betrieb der Vorrichtung zur Verfügung stehen.

In die Vorrichtung zur Strukturierung von Festkörperflächen mit lonenstrahlen aus einem lonenstrahlspektrum sind die Fokussierung von lonenstrahlen nach Erzeugung, Fokussierung und Separation der lonenstrahlen eingeschlossen. Die Vorrichtung erlaubt im Wesentlichen die Erzeugung von ladungs- oder massenseparierten Strahlen von Ionen mit annähernd beliebigen Ladungszustand und beliebiger Masse.

Weiterbildungen und weitere Ausgestaltungen der Erfindung sind in weiteren Unteransprüchen angegeben.

Die Erfindung wird anhand eines Ausführungsbeispiels mittels mehrerer Zeichnungen näher erläutert:
Es zeigen:
   Fig. 1 einen prinzipiellen Aufbau einer Vorrichtung zur Strukturierung von Festkörperflächen mit lonenstrahlen aus einem lonenstrahlspektrum,
   Fig. 2 eine schematische Darstellung des Aufbaus der magnetischen Flussführung eines Wienfilters mit variabler Sekundärspaltbreite,
   Fig. 3 eine schematische Darstellung des Wienfilters in einem Längsschnitt zur Funktionsweise,
   Fig. 4 ein Diagramm mit der in Eisenionen und Bleiionen gespeicherten potentiellen Energien als Funktion des lonenladungszustandes q und
   Fig. 5 eine Tabelle mit dem Spektrum möglicher lonenladungszustände in der Vorrichtung, dargestellt anhand ausgewählter chemischer Elemente.

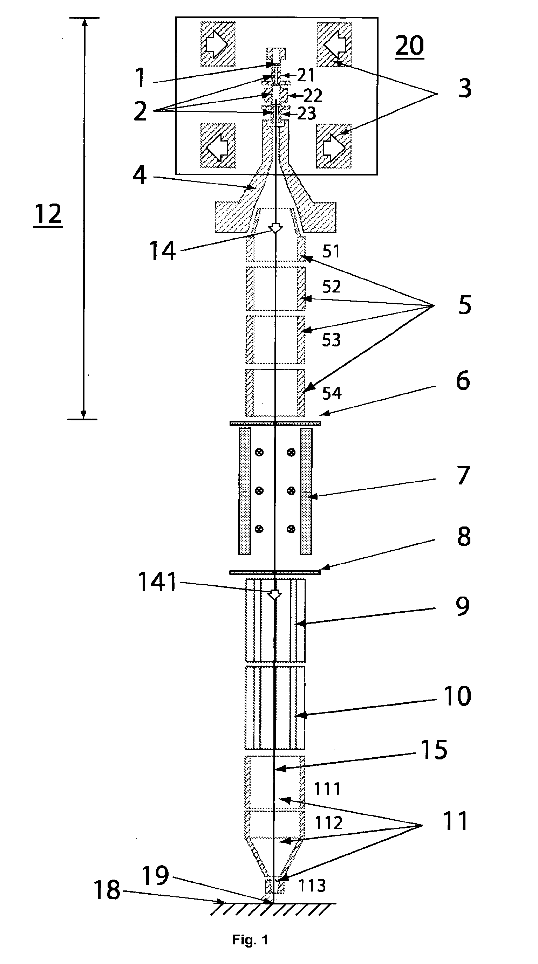

Die in Fig. 1 dargestellte Vorrichtung 20 zur Strukturierung einer Festkörperfläche 18 mit einem lonenstrahl 141 aus einem lonenstrahlspektrum 14, wobei das lonenstrahlspektrum 14 aus Ionen mit verschiedenen Ladungszuständen und unterschiedlichen Massen besteht, weist eine Baugruppe 21 zur Erzeugung des Ionenstrahlspektrums 14 mit Ionen verschiedener Ladungszustände und Massen mit einer Kathode 1, mit drei Driftröhrensektionen 21, 22, 23, mit einem Kollektor 4 sowie
eine Anordnung 5 von lonenextraktions- und Fokussierungslinsen auf einer gemeinsamen Strahlachse 15 und ein Permanentmagnetsystem 3 um die gemeinsame Strahlachse 15 auf, wobei das erzeugte lonenstrahlspektrum 14 in der Anordnung 5 von Extraktions- und Fokussierungslinsen extrahiert und von da aus auf ein nachfolgendes Wienfilter 7 fokussiert wird, das zur Ladungszustands- und Massenseparation eines extrahierten und fokussierten lonenstrahls 141 dient,
mindestens einen Deflektor 9, 10, der den lonenstrahl 141 stigmatisiert, positioniert und ablenkt, und
mindestens ein Objektiv 11, das den lonenstrahl 141 auf eine sehr kleine Festkörperfläche 18 im Fokus 19 feinfokussiert,
wobei das Wienfilter 7 aus einer Elektrodenanordnung 70 mit zwei Segmenten 71, 72 und einer zweipoligen Magnetanordnung 30, 31 aufgebaut ist, wobei ein angelegtes elektrisches Feld E, das orthogonal zur Bewegungsrichtung 73 des lonenstrahlspektrums 14 angeordnet ist und ein Magnetfeld B, welches orthogonal zur Bewegungsrichtung 73 des lonenstrahlspektrums 14 und orthogonal zum elektrischen Feld E ausgerichtet ist, vorgesehen sind sowie eingangsseitig eine Kollimatorblende 6 zum Passieren des lonenstrahlspektrums 14 und ausgangsseitig eine Massentrennblende 8 enthält, mit der das lonenstrahlspektrum 14 in seine Ionenstrahlen 141, 142, 143 entsprechend Masse und Ladungszustand zerlegt wird.

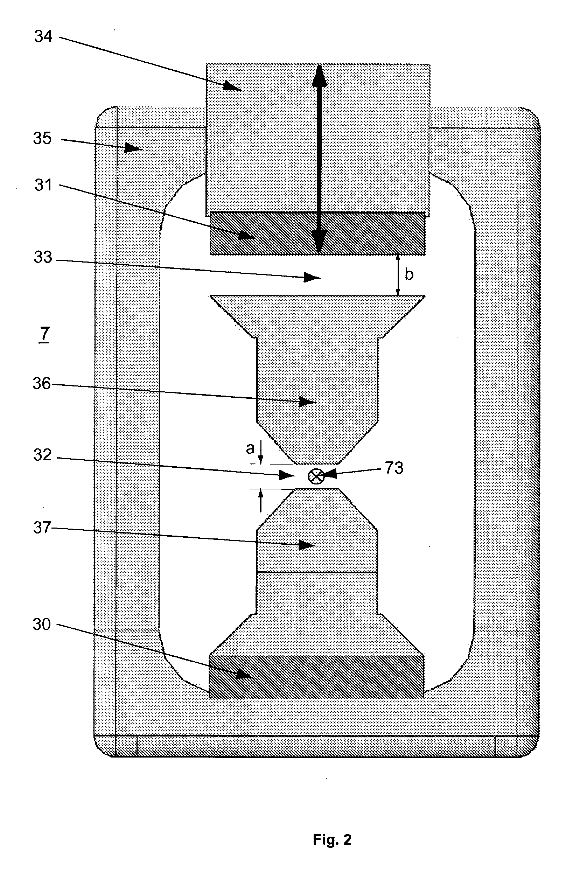

Erfindungsgemäß sind im Wienfilter 7, wie in Fig. 2 gezeigt ist, ein erster Permanentmagnet 30 innerhalb eines Eisenjochs 35 fest angeordnet, der einen zur Strahlachse 15 gerichteten konvergent ausgebildeten Polschuh 37 hat, und ein dem ersten Permanentmagneten gegenüberliegender zweiter Permanentmagnet 31, der mit einem am Eisenjoch 35 beweglich ausgebildeten ersten Polschuhteil 34 randseitig gehaltert ist und mit einem fest angeordneten, zur Strahlachse 15 gerichteten konvergent ausgebildeten zweiten Polschuhteil 36 versehen ist, wobei zwischen dem Polschuh 37 und dem zweiten Polschuhteil 36 ein primärer Magnetpolspalt 32 mit einem festen Spaltabstand a für den Durchgang des lonenstrahlspektrums 14 längs der Strahlachse 15 vorhanden ist, wobei zwischen den beiden Polschuhteilen 34, 36 ein sekundärer Magnetpolspalt 33 mit einer variablen Spaltbreite b vorhanden ist, wobei durch die Bewegung des beweglichen Polschuhteils 34 die Flussführung des magnetischen Feldes B im sekundären Magnetpolspalt 33 und gleichzeitig übertragend im primären Magnetpolspalt 32 mit dem Spaltabstand a variierbar ist.

Damit besitzt das Wienfilter 7 einen primären Magnetpolspalt 32 mit einem festen Spaltabstand a um die Strahlachse 15 und einen sekundären Magnetpolspalt mit einer variablen Spaltbreite b, womit in Abhängigkeit von der eingestellten Spaltbreite b des sekundären Magnetpolspalts 33 die Magnetfeldstärke B im primären Magnetpolspalt 32 variiert werden kann.

In Fig. 2 wird das magnetische Feld B durch die zwei Permanentmagnete 30 und 31 realisiert. Dabei wird die magnetische Feldstärke B im primären Magnetpolspalt 32 mit dem Spaltabstand a, den das lonenstrahispektrum 14 passiert, durch die variable Spaltbreite b des sekundären Magnetpolspalts 33 eingestellt. Die Spaltbreite b des sekundären Magnetpolspalts 33 kann durch Ein- und Ausfahren des beweglichen Polschuhs 34, an dem der Magnet 30 befestigt ist, am Eisenjoch 35 eingestellt werden. Die geschlossene magnetische Flussführung wird durch ein Eisenjoch 35 und zwei fixierte Polschuhe 36, 37 realisiert.

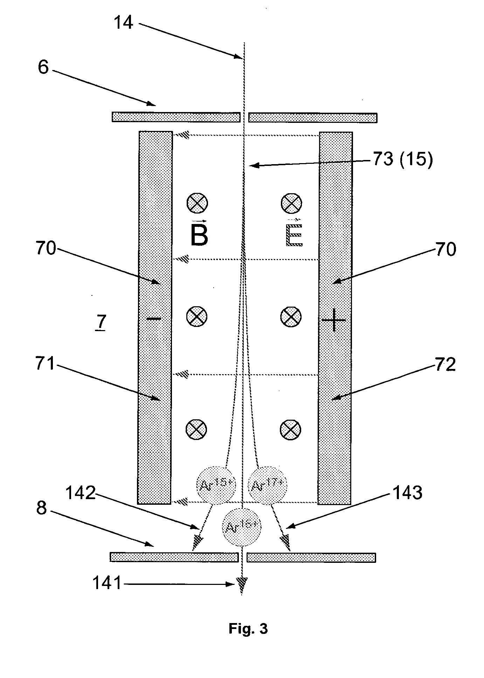

Das elektrische Feld E wird in der herkömmlichen Weise durch Anlegen eines variablen elektrischen Potenzials an die Elektrodenanordnung 70 in Fig. 3 erzeugt und kann durch Änderung des elektrischen Potenzials verändert werden.

Dabei weist das Wienfilter 7 ein angelegtes elektrisches Feld E, das orthogonal zur Bewegungsrichtung 73 des lonenstrahlspektrums 14 angeordnet ist, und ein Magnetfeld B auf, das orthogonal zur Bewegungsrichtung 73 des lonenstrahlspektrums 14 und orthogonal zum elektrischen Feld E ausgerichtet ist. Tritt das lonenstrahispektrum 14 in das Wienfilter 7 ein, wird das Ionenstrahlspektrum 14 durch das Kräfteverhältnis von Lorentzkraft und elektrischer Kraft ausgelenkt. Dabei passieren die lonen 141, die die Wienbedingung v = E/B erfüllen, wobei v die Geschwindigkeit des Ions, E das elektrische Feld und B das magnetische Feld sind, das Wienfilter 7 geradlinig entlang der Sollbahn 15. Bei der Wienbedingung besteht Kräftegleichgewicht zwischen Lorentzkraft und elektrischer Kraft. Die Geschwindigkeit v bestimmt sich aus dem Quellenstartpotenzial U, der Masse m und dem Ladungszustand q der Ionen 141,142,143 gemäß v = ((q x U)/(2 x m))^{0,5.}

In Fig. 3 ist dies für die Ladungszustände von Argonionen 141, 142, 143 gezeigt. Argon 16+ des lonenstrahls 141 erfüllt die Wienbedingung, d.h. die resultierenden Kräfte durch das magnetische Feld und durch das elektrische Feld heben sich gerade auf. Für den benachbarten Ladungszustand Argon 17+ des lonenstrahls 143 ist die Lorentzkraft F_{L} = q x v x B infolge des magnetischen Feldes B größer als die elektrische Kraft F_{E} = q x E und der lonenstrahl 143 wird von der Sollbahn 15 abgelenkt. Für den Ladungszustand Argon 15+ des lonenstrahls 142 ist die elektrische Kraft F_{E} größer als die Lorentzkraft F_{L} und es wird ebenfalls von der Sollbahn 15 abgelenkt. Dadurch enden die Trajektorien der lonenstrahlen 142, 143 an der Separationsblende 8, wohingegen der Ladungszustand Argon 16+ des lonenstrahls 141, der die Wienbedingung erfüllt, die Blende 8 geradlinig durch die zugehörige Öffnung passiert. Somit kann durch Einstellung des elektrischen Feldes E, aber auch durch Einstellen des magnetischen Feldes B die Wienbedingung für den ausgewählten lonenstrahl 141 mit dem vorgegebenen Ladungszustand oder für die vorgegebene Masse angepasst werden.

Die Form und die Größe der Linsen- und Blendenelemente können variabel sein.

Die einzelnen Komponenten der Anordnung 12 zur Fokussierung des lonenstrahlspektrums 14 sind wie folgt angeordnet:
Die Kathode 1, die Driftröhrensegmente 21, 22, 23 und der Kollektor 4 liegen auf der gemeinsamen Strahlachse 15 und dienen als Elektronenstoßionenquelle.

Dem Kollektor 4 folgen entlang der gemeinsamen Strahlachse 15 die Anordnung 5 mit lonenextraktions- und Fokussierungslinsen in der Reihenfolge
a) ein erstes zylindrisches Linsensegment 51 mit über seine axiale Ausdehnung variierenden oder konstantem Innendurchmesser,
b) ein zweites zylindrisches Linsensegment 52 mit über seine axiale Ausdehnung konstantem Innendurchmesser,
c) ein drittes zylindrisches Linsensegment 53 mit über seine axiale Ausdehnung konstantem Innendurchmesser,
d) ein viertes zylindrisches Linsensegment 54 mit über seine axiale Ausdehnung konstantem Innendurchmesser.

An das zylindrische Linsensegment 54 schließt sich eine Kollimatorblende 6 an, die auf der Strahlachse 15 eine Apertur mit variablem Durchmesser besitzt.

Der Kollimatorblende 6 folgt das Wienfilter 7, dessen Magnetpole aus Permanentmagneten oder Elektromagneten bestehen können.

Dem Wienfilter 7 folgt die Blende 8, die auf der Strahlachse 15 eine Apertur mit variablem Durchmesser besitzt und in Verbindung mit dem Wienfilter 7 als Massentrennblende funktioniert.

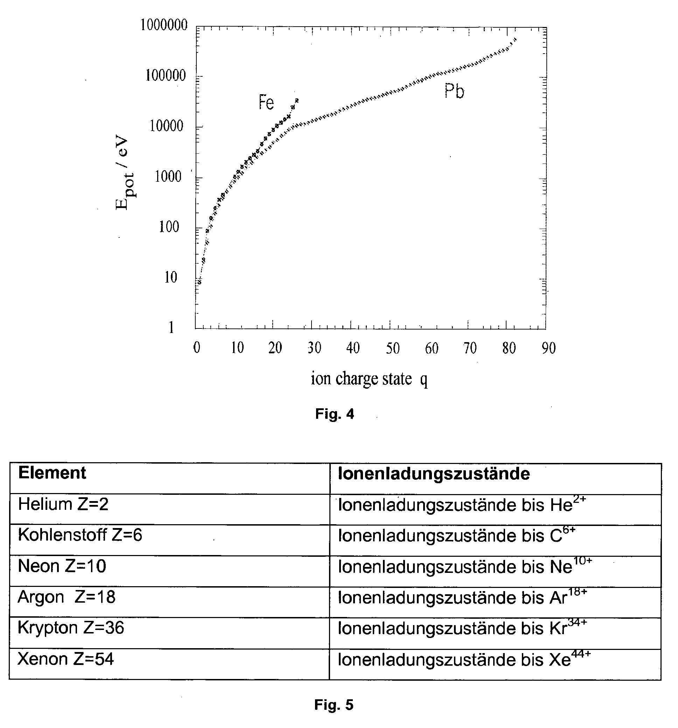

In Fig. 4 sind die in Eisenionen und Bleiionen gespeicherten potentiellen Energien als Funktion des lonenladungszustandes q angegeben. Somit kann sehr selektiv auf den kinetischen wie auch den potentiellen Energiebetrag der den lonenstrahl 141 formierenden Projektile Einfluss genommen werden und damit auch auf die Parameter - Eindringtiefe und Sputterrate - in der zu bestrahlenden Festkörperfläche 18. Spezifische Anwendungen erlauben somit Prozesse wie Oberflächenstrukturierungen, Oberflächenreinigen und ionenstrahlgestütztes Schreiben in Mikro- und Nanodimensionen.

In Fig. 5 ist das mögliche lonenstrahlspektrum 14 an Ladungszuständen für erfindungsgemäß fokussierte und selektierte lonenstrahlen 141 in einer Tabelle für ausgewählte Elemente dargestellt.

Die Funktionsweise der Vorrichtung 20 wird im Folgenden erläutert:
Nach der herkömmlichen Formierung des erzeugten lonenstrahlspektrums 14 werden die Ionen bei der Extraktion aus den Driftröhrensektionen 21, 22, 23 von der Elektronenkomponente des formierten lonenstrahlspektrums 14 in einem Elektronenkollektor 4 getrennt und durch die Anordnung 5 mit den Extraktions- und Fokussierungslinse extrahiert und fokussiert. Anschließend wird das Ionenstrahlspektrum 14 durch die Blenden 6, 8 kollimiert oder parallel ausgeblendet, durch das Wienfilter 7 in seine Komponenten - die lonenstrahlen 141, 142, 143 - ladungszustands- und massensepariert zerlegt.

Damit entsteht eine kompakte Baugruppe, die die Möglichkeiten einer Vorrichtung zur Fokussierung und zur Ladungszustand- und Massenseparation von Ionenstrahlen mit den Vorteilen einer EBIT als Quelle von Ionen unterschiedlicher chemischer Elemente in einem weiten Bereich von Ladungszuständen miteinander vereint.

Die Strahlblende 8 weist zwei Funktionen auf. Zum einen dient sie der weiteren Kollimierung des lonenstrahls 141. Des Weiteren erfolgt durch sie in Kombination mit dem Wienfilter 7 die Selektion des einzelnen lonenstrahls 141 durch eine Ausblendung der restlichen Komponenten 142, 143.

Die nachfolgende Deflektoranordnung besteht aus zwei hintereinander angeordneten elektrostatischen Deflektoren 9 und 10. Die Deflektoren 9 und 10 bestehen aus mindestens vier zylindrisch angeordneten Segmenten, besitzen vorteilhaft acht zylindrisch angeordnete Segmente.

Das nachfolgend angebrachte Objektiv 11 weist folgenden Aufbau auf:
- ein erstes Linsensegment 111 mit konstantem Innendurchmesser,
- ein zweites Linsensegment 112 mit über seine axiale Ausdehnung variierendem oder konstantem Innendurchmesser,
- ein drittes Linsensegment 113 mit über seine axiale Ausdehnung variierendem oder konstantem Innendurchmesser.

Die Vorrichtung 20 arbeitet in einem Druckbereich von 10⁻⁷ bis 10⁻¹¹ mbar. Es können prinzipiell Ionen aller im Periodensystem vorhandenen Elemente mit niedrigen bis hohen Ladungszuständen erzeugt, fokussiert und massensepariert werden.

### Bezugszeichenliste

- 1: Kathode
- 2: Driftröhre
- 21: Driftröhrensektion, Baugruppe zur Erzeugung des lonenstrahlspektrums, Driftröhrensegment
- 22: Driftröhrensektion, Driftröhrensegment
- 23: Driftröhrensektion, Driftröhrensegment
- 3: Permanentmagnetsystem, Permanentmagnetringe
- 4: Kollektor
- 5: Anordnung von lonenextraktions- und Fokussierungslinsen
- 51: erstes Linsensegment
- 52: zweites Linsensegment
- 53: drittes Linsensegment
- 54: viertes Linsensegment
- 6: Kollimatorblende
- 7: Wienfilter
- 70: Elektrodenanordnung
- 71: Segment, erste Elektrode
- 72: Segment, zweite Elektrode
- 73: Bewegungsrichtung
- 8: Massentrennblende, Separationsblende, Blende, Strahlblende
- 9: erster Deflektor
- 10: zweiter Deflektor
- 11: Objektiv
- 12: Anordnung der Fokussierung des Ionenstrahispektrums
- 111: Linsensegment, erstes Linsenobjektiv
- 112: Linsensegment, zweites Linsenobjektiv
- 113: Linsensegment, drittes Linsenobjektiv
- 14: lonenstrahlspektrum
- 141: lonenstrahl, Ionen
- 142: lonenstrahl, Ionen, lonenspezien
- 143: lonenstrahl, Ionen, lonenspezien
- 15: Strahlachse, Sollbahn
- 18: Festkörperfläche
- 19: Fokus
- 20: erfindungsgemäße Vorrichtung
- 30: erster Permanentmagnet, zweipolige Magnetanordnung, erster Magnet
- 31: zweiter Permanentmagnet, zweipolige Magnetanordnung, zweiter Magnet
- 32: primärer Magnetpolspalt
- 33: sekundärer Magnetpolspalt
- 34: beweglicher Polschuhteil, Polschuh
- 35: Eisenjoch
- 36: fester Polschuhteil, Polschuh
- 37: fester Polschuhteil, Polschuh

- a: Spaltabstand
- b: Spaltbreite
- q: lonenladungszustand
- v: Geschwindigkeit
- E: elektrisches Feld, elektrische Kraft
- B: Magnetfeld, magnetisches Feld, Magnetfeldstärke, magnetische Kraft
- F: elektrische Kraft, Lorentzkraft
- U: Quellenstartpotenzial
- m: Masse
- FIB: (engl.) Focussed Ion Beam
- AFM: (engl.) Atomic Force Microscope
- EBIT: (engl.) Electron Beam Ion Trap
- EBIS: (engl.) Electron Beam Ion Source
- table-top: Tisch-Größe (bezugnehmend auf die geometrischen Dimensionen)

## Patentansprüche

1. Vorrichtung (20) zur Strukturierung von Festkörperflächen (18) mit lonenstrahlen (141) aus einem lonenstrahlspektrum (14), wobei das Ionenstrahlspektrum (14) aus Ionen mit verschiedenen Ladungszuständen und unterschiedlichen Massen besteht, aufweisend
- eine Baugruppe (21) zur Erzeugung des lonenstrahlspektrums (14) mit Ionen verschiedener Ladungszustände und Massen mit einer Kathode (1), mit mehreren Driftröhrensektionen (21, 22, 23) und einem Kollektor (4),
- ein Permanentmagnetsystem (3) um eine gemeinsame Strahlachse (15) sowie
- eine Anordnung (5) von lonenextraktions- und Fokussierungslinsen auf der gemeinsamen Strahlachse (15) zum Extrahieren und Fokussieren des erzeugten lonenstrahlspektrums (14) auf ein nachfolgendes, zur Ladungszustands- und Massenseparation eines extrahierten und fokussierten lonenstrahls (141) ausgebildeten Wienfilters (7), wobei das Wienfilter (7)
- aus mindestens einer Elektrodenanordnung (70) mit mindestens zwei Segmenten (71, 72) und mindestens einer zweipoligen Magnetanordnung (30, 31) aufgebaut ist, wobei ein angelegtes elektrisches Feld E, welches orthogonal zur Bewegungsrichtung (73) des lonenstrahlspektrums (14) angeordnet ist, und ein Magnetfeld B, welches orthogonal zur Bewegungsrichtung (73) des lonenstrahlspektrums (14) und orthogonal zum elektrischen Feld E ausgerichtet ist, vorgesehen sind, sowie
- eingangsseitig eine Kollimatorblende (6) zum Passieren des lonenstrahlspektrums (14) und ausgangsseitig eine Massentrennblende (8) zum Zerlegen des lonenstrahlspektrums (14) in seine lonenstrahlen (141, 142, 143) entsprechend Masse und Ladungszustand, enthält,
- mindestens einen Deflektor (9, 10) zum Stigmatisieren, Positionieren und Ablenken des lonenstrahls (141) und
- mindestens ein Objektiv (11) zum Feinfokussieren des lonenstrahls (141) auf eine sehr kleine Festkörperfläche (18),
**dadurch gekennzeichnet, dass** im Wienfilter (7)
- ein erster Magnet (30) innerhalb eines Eisenjochs (35) fest angeordnet ist, welcher einen zur Strahlachse (15) gerichteten konvergent ausgebildeten Polschuh (37) aufweist, und
- ein dem ersten Magnet gegenüberliegender zweiter Magnet (31), welcher mit einem am Eisenjoch (35) beweglich ausgebildeten ersten Polschuhteil (34) randseitig gehaltert ist und mit einem fest angeordneten, zur Strahlachse (15) gerichteten konvergent ausgebildeten zweiten Polschuhteil (36) versehen ist, vorhanden ist,
wobei
- zwischen dem Polschuh (37) und dem zweiten Polschuhteil (36) ein primärer Magnetpolspalt (32) mit einem festen Spaltabstand a für den Durchgang des lonenstrahlspektrums (14) längs der Strahlachse (15) vorhanden ist und zwischen den beiden Polschuhteilen (34, 36) ein sekundärer Magnetpolspalt (33) mit einer variablen Spaltbreite b vorhanden ist, und
- durch die Bewegung des beweglichen Polschuhteils (34) die Flussführung des magnetischen Feldes B im sekundären Magnetpolspalt (33) und gleichzeitig übertragend im primären Magnetpolspalt (32) mit dem Spaltabstand a variierbar ist.

2. Vorrichtung (20) nach Anspruch 1, **dadurch gekennzeichnet, dass** das Wienfilter (7) einen primären Magnetpolspalt (32) mit einem festen Spaltabstand a um die Strahlachse (15) und einen sekundären Magnetpolspalt mit einer variablen Spaltbreite b besitzt, womit in Abhängigkeit von der eingestellten Spaltbreite b des sekundären Magnetpolspalts (33) die Magnetfeldstärke B im primären Magnetpolspalt (32) variierbar ist.

3. Vorrichtung (20) nach Anspruch 1 oder 2, **dadurch gekennzeichnet, dass** die Spaltbreite b des sekundären Magnetpolspalts (33) durch Ein- und Ausfahren des beweglichen Polschuhs (34), an dem der Magnet (30) befestigt ist, am Eisenjoch (35) einstellbar ist.

4. Vorrichtung (20) nach einem der Ansprüche 1 bis 3, **dadurch gekennzeichnet, dass** eine Anordnung (12) zur Fokussierung des lonenstrahlspektrums (14) vorhanden ist, die enthält die Kathode (1), die Driftröhrensegmente (21, 22, 23) und den Kollektor (4), die auf der Strahlachse (15) liegen und als Elektronenstoßionenquelle dienen, wobei dem Kollektor (4) entlang der Strahlachse (15) die Anordnung (5) mit lonenextraktions- und Fokussierungslinsen in der Reihenfolge nachfolgen, die enthält
a) ein erstes zylindrisches Linsensegment (51) mit über seine axiale Ausdehnung variierenden oder konstantem Innendurchmesser,
b) ein zweites zylindrisches Linsensegment (52) mit über seine axiale Ausdehnung konstantem Innendurchmesser,
c) ein drittes zylindrisches Linsensegment (53) mit über seine axiale Ausdehnung konstantem Innendurchmesser und
d) ein viertes zylindrisches Linsensegment (54) mit über seine axiale Ausdehnung konstantem Innendurchmesser,
wobei sich dem zylindrischen Linsensegment (54) die Kollimatorblende (6) anschließt, die auf der Strahlachse (15) eine Apertur mit variablem Durchmesser besitzt.

5. Vorrichtung (20) nach einem der Ansprüche 1 bis 4, **dadurch gekennzeichnet, dass** die Magnetpole des Wienfilters (7) aus Permanentmagneten oder Elektromagneten bestehen.

6. Vorrichtung (20) nach einem der Ansprüche 1 bis 5, **dadurch gekennzeichnet, dass** die Massentrennblende (8) auf der Strahlachse (15) eine Apertur mit variablem Durchmesser besitzt und in Verbindung mit dem Wienfilter (7) als Massentrennblende funktioniert.

7. Vorrichtung (20) nach einem der Ansprüche 1 bis 6, **dadurch gekennzeichnet, dass** die Massentrennblende (8) zwei Funktionen aufweist, wobei sie zum einen der weiteren Kollimierung des lonenstrahls (141) dient und des Weiteren durch sie in Kombination mit dem Wienfilter die Selektion eines Strahls einer einzelnen lonenspezies durch eine Ausblendung der restlichen lonenspezien (142, 143) erfolgt.

8. Vorrichtung (20) nach einem der Ansprüche 1 bis 7, **dadurch gekennzeichnet, dass** eine Deflektoranordnung aus zwei hintereinander angeordneten elektrostatischen Deflektoren (9, 10) besteht, wobei die Deflektoren (9, 10) aus mindestens vier zylindrisch angeordneten Segmenten bestehen oder vorzugsweise acht zylindrisch angeordnete Segmente besitzen.

9. Vorrichtung (20) nach einem der Ansprüche 1 bis 8, **dadurch gekennzeichnet, dass** das Objektiv (11) folgenden Aufbau aufweist:
- ein erstes Linsensegment (111) mit konstantem Innendurchmesser,
- ein zweites Linsensegment (112) mit über seine axiale Ausdehnung variierendem oder konstantem Innendurchmesser,
- ein drittes Linsensegment (113) mit über seine axiale Ausdehnung variierendem oder konstantem Innendurchmesser.

10. Vorrichtung (20) nach einem der Ansprüche 1 bis 9, **dadurch gekennzeichnet, dass** sie in einem Druckbereich von 10⁻⁷ bis 10⁻¹¹ mbar arbeitet, wobei Ionen aller im Periodensystem vorhandenen Elemente mit niedrigen bis hohen Ladungszuständen erzeugt, fokussiert und massensepariert zur Strukturierung einsetzbar sind.

## Claims

1. Device (20) for structuring solid surfaces (18) using ion beams (141) from an ion beam spectrum (14), wherein the ion beam spectrum (14) is composed of ions having different charge states and different masses, comprising:
- an assembly (21) for generating the ion beam spectrum (14) with ions having different charge states and different masses with a cathode (1), a plurality of drift-tube sections (21, 22, 23) and a collector (4),
- a permanent magnet system (3) surrounding a common beam axis (15) as well as
- an arrangement (5) of ion extraction and focusing lenses on said common beam axis (15) for extracting and focusing the generated ion beam spectrum (14) onto a consecutive Wien filter (7) being formed for the separation of the charge state and mass of an extracted and focused ion beam (141), wherein said Wien filter (7)
- is composed of at least one electrode arrangement (70) with at least two segments (71, 72) and at least one bipolar magnet arrangement (30, 31), wherein an applied electric field E, which is disposed orthogonally with respect to the direction of movement (73) of the ion beam spectrum (14), and a magnetic field B, which is oriented orthogonally with respect to the direction of movement (73) of the ion beam spectrum (14) and orthogonally with respect to the electric field E, are provided, and
- on the inlet side comprises a collimator diaphragm (6) for the passage of the ion beam spectrum (14) and on the outlet side comprises a mass separation diaphragm (8) for dispersing the ion beam spectrum (14) into its individual ion beams (141, 142, 143) as a function of mass and charge state,
- at least one deflector (9, 10) for stigmatizing, positioning and deflecting the ion beam (141) and
- at least one objective lens (11) for fine-focusing the ion beam (141) onto a tiny solid surface (18),
**characterized in that**
- a first magnet (30) is fixedly arranged in the Wien filter (7) within an iron yoke (35) and has a pole shoe (37) being directed to the beam axis (15) and being embodied in convergent fashion, and
- a second magnet (31) facing the first magnet, which is mounted at the edge via a first pole shoe member (34) being movably formed at the iron yoke (35) and being equipped with a fixedly arranged second pole shoe member (36) which is directed to the beam axis (15) and which is embodied in convergent fashion, is disposed, wherein
- a primary magnet pole gap (32) having a fixed gap distance a is provided between the pole shoe (37) and the second pole shoe member (36) to allow passage of the ion beam spectrum (14) longitudinally along the beam axis (15), and a secondary magnet pole gap (33) having a variable gap width b is provided between the two pole shoe members (34, 36), and
- in response to the movement of the movable pole shoe member (34) the flux passage of the magnetic field B in the secondary magnet pole gap (33), and in simultaneously transmitting manner in the primary magnet pole gap (32) having the gap distance a, is variable.

2. Device (20) according to claim 1,
**characterized in that**
the Wien filter (7) has a primary magnet pole gap (32) having a fixed gap distance a about the beam axis (15) and a secondary magnet pole gap having a variable gap width b, whereby the magnetic field strength B in the primary magnet pole gap (32) can be varied in dependence upon the adjusted gap width b of the secondary magnet pole gap (33).

3. Device (20) according to claim 1 or 2,
**characterized in that**
the gap width b of the secondary magnet pole gap (33) can be adjusted at the iron yoke by retracting and deploying the movable pole shoe (34) having the magnet (30) attached thereto.

4. Device (20) according to any of claims 1 to 3,
**characterized in that**
an arrangement (12) for focusing the ion beam spectrum (14) is provided, which comprises the cathode (1), the drift-tube segments (21, 22, 23) and the collector (4) which are located on the beam axis (15) and which serve as electron impact ion source, wherein along the beam axis (15) the collector (4) is adjoined by the arrangement (5) of ion extraction and focusing lenses in sequence, which comprises:
a) a first cylindrical lens segment (51) with a varying or constant inner diameter over its axial extension,
b) a second cylindrical lens segment (52) with a constant inner diameter over its axial extension,
c) a third cylindrical lens segment (53) with a constant inner diameter over its axial extension and
d) a fourth cylindrical lens segment (54) with a constant inner diameter over its axial extension,
wherein the cylindrical lens segment (54) is adjoined by the collimator diaphragm (6) which on the beam axis (15) has an aperture with a variable diameter.

5. Device (20) according to any of claims 1 to 4,
**characterized in that**
the magnet poles of the Wien filter (7) are composed of permanent magnets or electromagnets.

6. Device (20) according to any of claims 1 to 5,
**characterized in that**
the mass separation diaphragm (8) on the beam axis (15) has an aperture with a variable diameter and in communication with the Wien filter (7) operates as a mass separation diaphragm.

7. Device (20) according to any of claims 1 to 6,
**characterized in that**
the mass separation diaphragm (8) has two functions, on the one hand serving for further collimation of the ion beam (141) and on the other hand, in combination with the Wien filter, realizing a selection of a beam of an individual ion species by masking the remaining ion species (142, 143).

8. Device (20) according to any of claims 1 to 7,
**characterized in that**
a deflector arrangement is composed of two consecutively arranged electrostatic deflectors (9, 10), wherein said deflectors (9, 10) are composed of at least four cylindrically disposed segments or preferably feature eight cylindrically disposed segments.

9. Device (20) according to any of claims 1 to 8,
**characterized in that**
the objective lens (11) is designed with the following components:
- a first lens segment (111) with a constant inner diameter,
- a second lens segment (112) with a varying or constant inner diameter over its axial extension,
- a third lens segment (113) with a varying or constant inner diameter over its axial extension.

10. Device (20) according to any of claims 1 to 9,
**characterized in that**
the device operates in a pressure range of 10⁻⁷ to 10⁻¹¹ mbar, wherein ions among all elements present in the periodic system with low to high charge states are generated, focused and can be employed in mass-separated manner for structuring.

## Revendications

1. Dispositif (20) destiné à la structuration de surfaces solides (18) à l'aide de faisceaux ioniques (141) provenant d'un spectre de faisceaux ioniques (14), dans lequel le spectre de faisceaux ioniques (14) est composé d'ions ayant différents d'états de charge et des masses distinctes, comprenant le suivant:
- un module (21) destiné à la génération du spectre de faisceaux ioniques (14) présentant des ions ayant différents états de charge et des masses distinctes avec une cathode (1), une pluralité de sections de tubes de glissement (21, 22, 23) et un collecteur (4),
- un système d'aimants permanents (3) entourant un axe de rayonnement commun (15) ainsi qu'
- un agencement (5) de lentilles d'extraction et de focalisation disposées sur ledit axe de rayonnement commun (15) permettant l'extraction et la focalisation du spectre de faisceaux ioniques (14) généré sur un filtre de Wien (7) consécutif étant conçu pour la séparation de l'état de charge et de la masse d'un faisceau ionique (141) extrait et focalisé, dans lequel ledit filtre de Wien (7)
- est composé d'au moins un agencement d'électrodes (70) présentant au moins deux segments (71, 72) et au moins un ensemble magnétique bipolaire (30, 31), dans lequel un champ électrique E appliqué, étant disposé orthogonalement par rapport à la direction de mouvement (73) du spectre de faisceaux ioniques (14), et un champ magnétique B, étant orienté orthogonalement par rapport à la direction de mouvement (73) du spectre de faisceaux ioniques (14) et orthogonalement par rapport au champ électrique E, sont prévus, et
- le filtre de Wien comprend un diaphragme de collimateur (6) sur le côté d'entrée permettant le passage du spectre de faisceaux ioniques (14) et un diaphragme de séparation de masses (8) sur le côté de sortie permettant la dispersion du spectre de faisceaux ioniques (14) en les faisceaux ioniques (141, 142, 143) individuels de celle-ci en fonction de la masse et l'état de charge,
- au moins un déflecteur (9, 10) pour stigmatiser, positionner et dévier le faisceau ionique (141) et
- au moins une lentille objective (11) pour la focalisation de manière fine du faisceau ionique (141) sur une surface solide (18) minuscule,
**caractérisé en ce qu'**
- un premier aimant (30) est agencé de manière fixe dans le filtre de Wien (7) dans un joug de fer (35) et présente un épanouissement polaire (37) étant dirigé vers l'axe de rayonnement (15) et étant conçu de façon convergente, et
- un second aimant (31) faisant face au premier aimant, qui est monté sur le bord par une première partie d'épanouissement polaire (34) étant formée au joug de fer (35) de manière mobile, et qui est pourvu d'une seconde partie d'épanouissement polaire (36) étant agencée de manière fixe, dirigée vers l'axe de rayonnement (15) et étant conçue de façon convergente, est disposé, dans lequel
- un entrefer d'aimant primaire (32) ayant une distance d'entrefer a fixe est pourvu entre l'épanouissement polaire (37) et la seconde partie d'épanouissement polaire (36) permettant le passage du spectre de faisceaux ioniques (14) longitudinalement le long de l'axe de rayonnement (15), et un entrefer d'aimant secondaire (33) ayant une largeur d'entrefer b variable est pourvu entre les deux parties d'épanouissement polaires (34, 36), et
- le passage de flux du champ magnétique B dans l'entrefer d'aimant secondaire (33), de manière simultanément transmettant dans l'entrefer d'aimant primaire (32) ayant la distance d'entrefer a, est variable en réponse au mouvement de la partie d'épanouissement polaire (34) mobile.

2. Dispositif (20) selon la revendication 1,
**caractérisé en ce que**
le filtre de Wien (7) présente un entrefer d'aimant primaire (32) ayant une distance d'entrefer a fixe autour de l'axe de rayonnement (15) et présente un entrefer d'aimant secondaire ayant une largeur d'entrefer b variable, dans lequel l'intensité du champ magnétique B dans l'entrefer d'aimant primaire (32) peut être variée en fonction du largeur d'entrefer *b* de l'entrefer d'aimant secondaire (33).

3. Dispositif (20) selon l'une quelconque des revendications 1 à 2, **caractérisé en ce que**
la largeur d'entrefer *b* de l'entrefer d'aimant secondaire (33) peut être réglée au niveau du joug de fer en rétractant et en déployant l'épanouissement polaire (34) mobile ayant l'aimant (30) fixé à celui-ci.

4. Dispositif (20) selon l'une quelconque des revendications 1 à 3, **caractérisé en ce qu'**
un agencement (12) pour focaliser le spectre de faisceaux ioniques (14) est prévu, comprenant la cathode (1), les segments de tubes de glissement (21, 22, 23) et le collecteur (4) étant disposés sur l'axe de rayonnement (15) et servant comme source ionique d'impact d'électrons, dans lequel le long de l'axe de rayonnement (15) le collecteur (4) jouxtent l'agencement (5) de lentilles d'extraction d'ions et de focalisation, qui comprend le suivant:
a) un premier segment de lentilles cylindrique (51) ayant un diamètre intérieur variable ou constant le long de son extension axial,
b) un second segment de lentilles cylindrique (52) ayant un diamètre intérieur constant le long de son extension axial,
c) un troisième segment de lentilles cylindrique (53) ayant un diamètre intérieur constant le long de son extension axial, et
d) un quatrième segment de lentilles cylindrique (54) ayant un diamètre intérieur constant le long de son extension axial,
dans lequel le segment de lentilles cylindrique (54) jouxtent le diaphragme de collimateur (6) présentant une aperture ayant un diamètre variable sur l'axe de rayonnement (15).

5. Dispositif (20) selon l'une quelconque des revendications 1 à 4,
**caractérisé en ce que**
les pôles magnétiques du filtre de Wien (7) sont composés d'aimants permanents ou d'électroaimants.

6. Dispositif (20) selon l'une quelconque des revendications 1 à 5,
**caractérisé en ce que**
le diaphragme de séparation de masses (8) sur l'axe de rayonnement (15) présente une aperture ayant un diamètre variable, et en communication avec le filtre die Wien (7) fonctionne comme un diaphragme de séparation de masses.

7. Dispositif (20) selon l'une quelconque des revendications 1 à 6,
**caractérisé en ce que**
le diaphragme de séparation de masses (8) a deux fonctions, d'une part servant pour collimater davantage le faisceau ionique (141) et d'autre part, en combinaison avec le filtre de Wien, permettant une sélection d'un faisceau d'une espèce ionique individuelle en masquant les espèces ioniques restantes (142, 143).

8. Dispositif (20) selon l'une quelconque des revendications 1 à 7,
**caractérisé en ce qu'**
un agencement de déflecteurs est composé de deux déflecteurs électrostatiques étant agencés de manière consécutive (9, 10), dans lequel les déflecteurs (9, 10) sont composés d'au moins quatre segments disposés de forme cylindrique ou de préférence présentant huit segments disposés de forme cylindrique.

9. Dispositif (20) selon l'une quelconque des revendications 1 à 8,
**caractérisé en ce que**
la lentille objective (11) est conçue avec les composants suivants:
- un premier segment de lentille (111) ayant un diamètre intérieur constant,
- un second segment de lentille (112) ayant un diamètre intérieur variable ou constant le long de son extension axial,
- un troisième segment de lentille (113) ayant un diamètre intérieur variable ou constant le long de son extension axial.

10. Dispositif (20) selon l'une quelconque des revendications 1 à 9,
**caractérisé en ce que**
le dispositif fonctionne dans une plage de pression allant de 10⁻⁷ à 10⁻¹¹ mbar, dans lequel d'ions parmi tous les éléments présents dans le système periodique ayant des états de charge faibles jusqu'à fortes sont générés, focalisés et peuvent être utilisés de manière séparée en masses pour la structuration.
